# EUROPEAN PATENT APPLICATION

(11) **EP 1 168 583 A2**
(43) Date of publication of application: **02.01.2002**
(21) Application number: 01111461.8
(22) Date of filing: 10.05.2001
(51) Int. Cl.: H02K 11/04

(54) **Alternator for vehicle**

(30) Priority: 28.06.2000 KR 2000035872
(71) Applicant: Valeo Mando Electrical Systems Korea Limited, Kyongju-si, Kyongsangbuk-do (KR)
(72) Inventor: Seo, Dong-Won, Kyongju-si, Kyongsangbuk-do, 780-140 (KR)
(74) Representative: TER MEER STEINMEISTER & PARTNER GbR

(57) **Abstract**

The present invention relates to an alternator for a vehicle which is capable of enhancing a performance of a fan by forming a hole (110) in a flat plate with respect to a heat sink (100) in the (-) direction between two heat sinks, inserting a diode (10) therein for thereby obtaining an inherent heat sink operation and forming a certain surface at one side thereof opposite to the fan and supporting a brush holder and an alternator. In the present invention, there is provided an alternator for a vehicle in which a heat sink (100) is formed by a circular die casting method, a hole (110) in which a diode (10) is installed is formed at a certain portion, and protrusion (120) is formed in a certain portion of the circumferential surface for thereby enhancing a performance of a fan and supporting a brush holder and rectifier in an alternator for a vehicle in which a diode (10) capable of converting an alternating current into a direct current is installed in a heat sink (100) for thereby radiating heat.

## Description

### BACKGROUND OF THE INVENTION

### 1. Field of the Invention

The present invention relates to an alternator for a vehicle, and in particular to an alternator for a vehicle which is capable of implementing an inherent operation of a heat sink and enhancing a performance of a fan.

### 2. Description of the Background Art

Generally, an alternator represents a synchronous alternator as a representative one of an alternator capable of generating an alternating current power. When rotating a magnetic pole in a fixed conductive member(coil), an electromotive force of an alternating current is generated in a conductive member. The thusly generated electromotive force is expressed by an equation of f=(p*n)/120) assuming that the frequency is f(Hz), and the revolution of the magnetic pole is n(rpm), and the number of magnetic poles is p.

In addition, the electromotive force is proportional to a square of the number of the magnetic force lines and the revolution which are generated by the magnetic pole. In order to obtain a constant frequency, the alternator is driven at a constant revolution.

Therefore, in order to change the size of the electromotive force, the current of the exciting coil wound on the magnetic pole is adjusted. A single phase and three phase are provided. The three phase is generally used. The single phase is rarely used.

The type of the motors is classified into a waterwheel type alternator driven by a waterwheel, a turbine alternator driven by a steam turbine or gas turbine and an engine alternator driven by a combustion engine.

Here, in the operation of the alternating current alternator, when an ignition switch is closed, the current of the battery is flown to a rotor coil from a F terminal of the alternator through an IG and F terminal of a voltage regulator for thereby forming a magnetic field in a rotor.

When the engine is started, and the rotor is rotated, a power generating operation is performed in a stator coil for thereby generating a three phase power.

The thusly generated three phase alternating current is rectified by the diode and is flown to the B terminal. When the voltage of the B terminal is higher than the voltage of the battery, the battery is charged, and the current is supplied to each electric load.

As the revolution of the alternator is gradually increased, and the voltage of the B terminal is reached at a certain set value, the voltage regulator is started, and the current flowing to the rotor coil is decreased. Therefore, the power generating operation of the alternator is controlled, and the voltage of the B terminal is maintained at the set value.

When the engine is stopped, the current may reverserly flown from the battery to the alternator. However, the thus reverse flow of the current is prevented by the diode.

The voltage of the alternator is maintained at a set value and is supplied to the battery and the electrical devices of each unit.

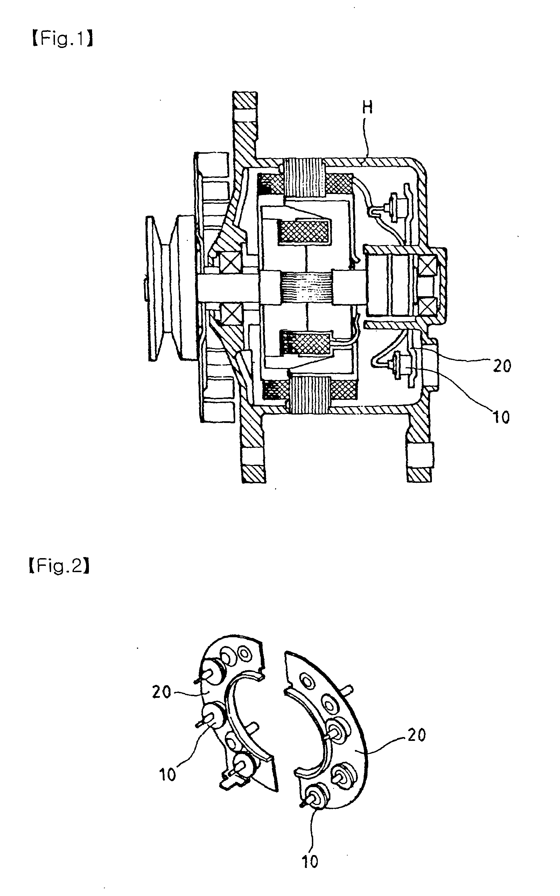

As shown in Figures 1 and 2, six or eight diodes 10 capable of converting the alternating current into a direct current are attached to two heat sinks 20 by two kinds for thereby radiating heat generated during the rectifying operation. In the conventional alternator, two heat sinks are additionally fabricated, and the cooling performance of the fan is bad.

### SUMMARY OF THE INVENTION

Accordingly, it is an object of the present invention to provide an alternator for a vehicle which overcomes the problems encountered in the conventional art.

It is another object of the present invention to provide an alternator for a vehicle which is capable of enhancing a performance of a fan by forming a hole in a flat plate with respect to a heat sink in the (-) direction between two heat sinks, inserting a diode therein for thereby obtaining an inherent heat sink operation and forming a certain surface at one side thereof opposite to the fan and supporting a brush holder and an alternator.

To achieve the above objects, there is provided an alternator for a vehicle in which a heat sink is formed by a circular die casting method, a hole in which a diode is installed is formed at a certain portion, and protrusion is formed in a certain portion of the circumferential surface for thereby enhancing a performance of a fan and supporting a brush holder and rectifier in an alternator for a vehicle in which a diode capable of converting an alternating current into a direct current is installed in a heat sink for thereby radiating heat.

### BRIEF DESCRIPTION OF THE DRAWINGS

The present invention will become better understood with reference to the accompanying drawings which are given only by way of illustration and thus are not limitative of the present invention, wherein:
Figure 1 is a cross-sectional view illustrating a conventional alternator for a vehicle;
Figure 2 is a perspective view illustrating a state that a diode is installed in a heat sink in the conventional art; and
Figure 3 is a perspective view illustrating a flat plate of an alternator for a vehicle according to the present invention.

### DETAILED DESCRIPTION OF THE PREFERRED EMBODIMENTS

The embodiments of the present invention will be explained with reference to the accompanying drawings.

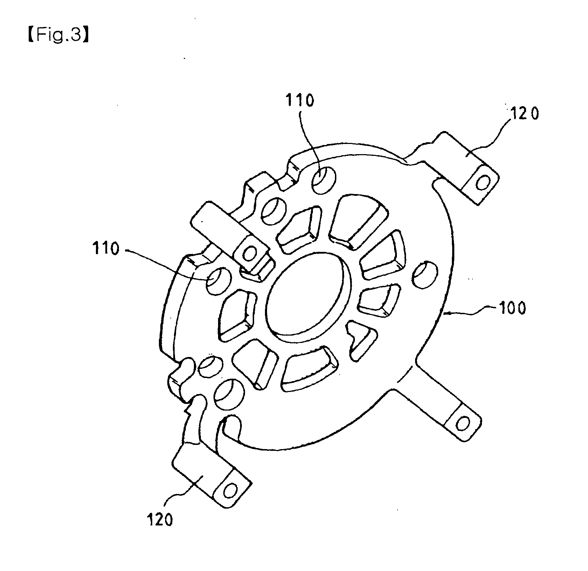

Figure 3 is a perspective view illustrating a flat plate of an alternator for a vehicle according to the present invention.

In an alternator for a vehicle in which a diode 10 capable of converting an alternating current into a direct current is installed in a heat sink 100 for thereby radiating heat, an alternator for a vehicle in which the heat sink 100 is formed by a circular die casting method, a hole 110 in which a diode 10 is installed is formed at a certain portion, and protrusion 120 is formed in a certain portion of the circumferential surface for thereby enhancing a performance of a fan and supporting a brush holder and rectifier.

In the heat sink 100, the number of the holes 110 formed in the circular plate is determined based on the number of the diodes 10 inserted therein.

The height of the protrusion 120 is determined based on the length of a housing H of the alternator.

Therefore, since the heat sink 100 of the alternator is integrally formed based on the die casting method, it is possible to implement an easier assembling operation. In addition, the diode 10 installed in the heat sink 100 is capable of radiating heat generated during the rectifying operation to the heat sink 100.

At this time, a smooth flow of the fluid introduced by the fan is implemented by the protrusion for thereby enhancing a cooling performance.

As described above, in the present invention, a hole is formed in a flat shaped plate with respect to a heat sink in the (-) direction between two heat sinks, and a diode is inserted therein for thereby implementing an inherent operation of the heat sink and enhancing a performance of the fan by forming a certain surface at one side thereof opposite to the fan and supporting a brush holder and an alternator.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the meets and bounds of the claims, or equivalences of such meets and bounds are therefore intended to be embraced by the appended claims.

## Claims

1. In an alternator for a vehicle in which a diode capable of converting an alternating current into a direct current is installed in a heat sink for thereby radiating heat, an alternator for a vehicle in which the heat sink is formed by a circular die casting method, a hole in which a diode is installed is formed at a certain portion, and protrusion is formed in a certain portion of the circumferential surface for thereby enhancing a performance of a fan and supporting a brush holder and rectifier.
